# EUROPÄISCHE PATENTANMELDUNG

(11) **EP 4 613 161 A1**
(43) Veröffentlichungstag der Anmeldung: **10.09.2025**
(21) Anmeldenummer: 25157308.5
(22) Anmeldetag: 12.02.2025
(51) Int. Cl.: A47L 5/24, A47L 9/00, A47L 9/28, A47L 9/32

(54) **SAUGEINHEIT MIT FRISCHLUFTKÜHLUNG**

(30) Priorität: 04.03.2024 DE 102024202005
(71) Anmelder: BSH Hausgeräte GmbH, 81739 München (DE)
(72) Erfinder: Back, Sebastian, 97724 Burglauer (DE); Bockelt, Stefan, 97618 Rödelmaier (DE); Fromm, Christian, 97616 Bad Neustadt (DE); Scheler, Christian, 97618 Rödelmaier (DE); Stengel, Marcel, 97633 Sulzfeld (DE); Stobert, Christian, 97618 Hohenroth (DE); Schnitzer, Frank, 97616 Bad Neustadt (DE); Hamm, Silvio, 98617 Sülzfeld (DE)

(57) **Zusammenfassung**

Es wird eine Saugeinheit (110) für eine handgeführte Saugvorrichtung (100) beschrieben, wobei die Saugeinheit (110) ein Gebläse (200) umfasst, das ausgebildet ist, einen Haupt-Saugluftstrom (240) von dem Saugmund (114), über eine Abscheideeinheit (113) zu dem Gebläse (200) der Saugeinheit (110) zu bewirken. Die Saugeinheit (110) umfasst einen Handgriff (112) mit einem durch eine Gehäusewand gebildeten Hohlraum, in dem eine Elektronik-Komponente (221) angeordnet ist, wobei der Hohlraum ein oder mehrere Einlassöffnungen (213) in der Gehäusewand aufweist. Des Weiteren umfasst die Saugeinheit (110) einen Bypass-Kanal (210), der einen dem Hohlraum zugewandten Einlass (211) und einen dem Gebläse (200) zugewandten Auslass (212) aufweist, wobei das Gebläse (200) ausgebildet ist, einen Bypass-Luftstrom (220) von den ein oder mehreren Einlassöffnungen (213), durch den Hohlraum, durch den Bypass-Kanal (210) zu dem Gebläse (200) zu bewirken. Der Hohlraum ist an der dem Einlass (211) des Bypass-Kanals (210) zugewandten Seite durch ein Abschirmelement (230) bedeckt, das ausgebildet ist, den Hohlraum von Feuchtigkeit aus dem Haupt-Saugluftstrom (240) und/oder aus Abluft (241) des Gebläses (200) abzuschirmen, wobei das Abschirmelement (230) eine abgedichtete Öffnung (231) aufweist, in der der Einlass (211) des Bypass-Kanals (210) angeordnet ist.

## Beschreibung

Die Erfindung betrifft eine Saugeinheit für eine Saugvorrichtung, insbesondere für einen kabellosen und/oder handgeführten Saug-Wischer.

Eine Saugvorrichtung, insbesondere ein Handstaubsauger, umfasst typischerweise eine Saugeinheit, die von einem Nutzer mit der Hand getragen und geführt werden kann. Die Saugeinheit weist ein Gebläse auf, das mit elektrischer Energie aus einem elektrischen Energiespeicher der Saugeinheit betrieben wird. Das Gebläse ist ausgebildet, einen Saugluftstrom zu erzeugen, um Verunreinigungen durch einen Saugmund der Saugeinheit in einen Auffangbehälter der Saugeinheit zu saugen. Der Saugmund der Saugeinheit ist typischerweise als Kupplung ausgebildet, über die jeweils ein Zubehörteil aus einer Menge von unterschiedlichen Zubehörteilen mit der Saugeinheit verbunden werden kann. Ein beispielhaftes Zubehörteil ist eine Nassreinigungsdüse, die es ermöglicht, eine zu reinigende Fläche gleichzeitig zu wischen und abzusaugen.

Wenn die Saugvorrichtung als kombinierter Saug-Wischer verwendet wird, kann der Saugluftstrom Feuchtigkeit aufweisen, sodass der Saugluftstrom nicht mehr ohne Weiteres zur Kühlung der Elektronik der Saugeinheit genutzt werden kann.

DE 17 03 970 A beschreibt einen Staubsauger mit einem Einlassloch für Außenluft. EP 3 763 265 A1 beschreibt ein tragbares Sauggerät. DE 10 2012 207 348 A1 beschreibt einen Staubsauger mit einem Nebenluftkanal. DE 10 2014 200 663 A1 beschreibt einen akkubetriebenen Handstaubsauger. DE 20 2012 101 781 U1 beschreibt ein Hartflächenabsauggerät.

Das vorliegende Dokument befasst sich mit der technischen Aufgabe, eine effiziente und zuverlässige Kühlung der Elektronik der Saugeinheit einer Saugvorrichtung zu bewirken, insbesondere einer Saugvorrichtung, die als Saug-Wischer genutzt werden kann, sodass der Saugluftstrom Feuchtigkeit aufweisen kann.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt wird eine Saugeinheit für eine handgeführte Saugvorrichtung beschrieben. Die Saugeinheit umfasst ein Gebläse, das ausgebildet ist, einen Haupt-Saugluftstrom von dem Saugmund (bzw. dem Saugrohr) der Saugeinheit, über die Abscheideeinheit der Saugeinheit zu dem Gebläse der Saugeinheit zu bewirken. An dem Saugmund bzw. dem Saugrohr kann ggf. eine Nassreinigungsdüse angeschlossen sein, sodass der Haupt-Saugluftstrom (neben Staub) Feuchtigkeit umfassen kann. Das Gebläse kann entlang einer Hochachse der Saugeinheit oberhalb der Abscheideeinheit angeordnet sein. Die Abscheideeinheit umfasst typischerweise einen Sammelbehälter zur Aufnahme von aufgesaugtem Schmutz.

Die Saugeinheit umfasst ferner einen Handgriff mit einem durch eine Gehäusewand gebildeten Hohlraum, in dem eine Elektronik-Komponente angeordnet ist (wobei die Elektronik-Komponente zur Steuerung des Gebläses ausgebildet sein kann). Der Hohlraum weist ein oder mehrere Einlassöffnungen in der Gehäusewand auf. Der Handgriff kann ausgebildet sein, von einem Nutzer mit einer Hand umschlossen zu werden, um die Saugeinheit zu halten. Der Handgriff kann entlang einer Längsachse der Saugeinheit (die senkrecht zu der Hochachse verläuft) hinter dem Gebläse und der Abscheideeinheit angeordnet sein. Der Handgriff kann sich (wie der Henkel eines Krugs) entlang der Hochachse von der Oberseite der Saugeinheit (an der das Gebläse angeordnet ist) bis zu der Unterseite der Saugeinheit (an der der Energiespeicher der Saugeinheit und/oder an der die Unterseite der Abscheideeinheit angeordnet ist) erstrecken. Der Hohlraum mit der Elektronik-Komponente kann an der Unterseite der Saugeinheit angeordnet sein (entlang der Hochachse direkt über der Halterung für den Energiespeicher).

Der Handgriff kann Teil eines Gehäuses der Saugeinheit sein. In dem Gehäuse kann auch das Gebläse angeordnet sein. Ferner kann das Gehäuse einen Anschlussbereich aufweisen, der der Seitenwand der Abscheideeinheit (mit dem Sammelbehälter) zugewandt ist, und die sich von der Unterseite bis zu der Oberseite der Saugeinheit erstreckt. Der Anschlussbereich kann sich somit im Wesentlichen entlang der Hochachse erstrecken. Der Handgriff kann zusammen mit dem Anschlussbereich einen Ring bilden.

Der Anschlussbereich kann eine Kupplung aufweisen, an der die Abscheideeinheit an dem Gehäuse der Saugeinheit befestigt werden kann.

Die Saugeinheit umfasst ferner einen Bypass-Kanal, der einen dem Hohlraum zugewandten Einlass und einen dem Gebläse zugewandten Auslass aufweist. Der Bypass-Kanal kann innerhalb des Anschlussbereichs des Gehäuses der Saugeinheit verlaufen. Dabei kann der Bypass-Kanal entlang der Hochachse von der Unterseite der Saugeinheit (an der der Hohlraum angeordnet ist) bis zu der Oberseite der Saugeinheit (an der das Gebläse angeordnet ist) verlaufen. Der Bypass-Kanal kann einen Bypass-Schlauch umfassen. Insbesondere kann der Bypass-Kanal in effizienter Weise als Bypass-Schlauch ausgebildet sein.

Das Gebläse ist ausgebildet, einen Bypass-Luftstrom von den ein oder mehreren Einlassöffnungen, durch den Hohlraum, durch den Bypass-Kanal zu dem Gebläse zu bewirken. Das Gebläse wird somit befähigt, zusätzlich zu und separat von dem Haupt-Saugluftstrom einen Bypass-Luftstrom zu erzeugen, um eine effiziente und zuverlässige Kühlung der Elektronik-Komponente zu bewirken. Der Bypass-Luftstrom weist dabei frische Umgebungsluft auf, sodass eine besonders zuverlässige Kühlung bewirkt werden kann. Ferner ist der Bypass-Luftstrom nicht durch Feuchtigkeit aus dem Haupt-Saugluftstrom belastet, sodass eine schonende Kühlung der Elektronik-Komponente bewirkt werden kann.

Die Elektronik-Komponente kann eine dem Einlass des Bypass-Kanals zugewandte erste Kante aufweisen. Die ein oder mehreren Einlassöffnungen sind bevorzugt an der von dem Einlass des Bypass-Kanals abgewandten zweiten Kante der Elektronik-Komponente angeordnet, wobei die erste und die zweite Kante der Elektronik-Komponente einander gegenüber angeordnet sind. So kann eine besonders zuverlässige Kühlung der Elektronik-Komponente bewirkt werden.

Die Elektronik-Komponente weist (in Bezug auf die Hochachse) eine erste Seite (insbesondere eine Unterseite) und eine zweite Seite (insbesondere eine Oberseite) auf. Die ein oder mehreren Einlassöffnungen können der ersten Seite (insbesondere der Unterseite) der Elektronik-Komponente zugewandt sein, und der Einlass des Bypass-Kanals kann der zweiten Seite (insbesondere der Oberseite) der Elektronik-Komponente zugewandt sein. So kann eine besonders zuverlässige Kühlung der Elektronik-Komponente durch den Bypass-Luftstrom bewirkt werden.

Der Einlass des Bypass-Kanals kann eine Verengung in Bezug auf den Hohlraum darstellen, sodass der Bypass-Luftstrom innerhalb des Hohlraums zu dem Einlass des Bypass-Kanals hin beschleunigt und/oder verdichtet wird. So kann der Kühlungseffekt weiter verbessert werden.

Der Hohlraum ist an der dem Einlass des Bypass-Kanals zugewandten Seite bevorzugt durch ein Abschirmelement bedeckt, das ausgebildet ist, den Hohlraum von Feuchtigkeit aus dem Gebläse und/oder aus dem Haupt-Saugluftstrom und/oder aus der Abluft aus dem Gebläse abzuschirmen. Das Abschirmelement weist dabei bevorzugt eine abgedichtete Öffnung (mit einer ringförmigen Dichtung) auf, in der der Einlass des Bypass-Kanals angeordnet ist. Durch die Bereitstellung eines wandförmigen Abschirmelements kann die Elektronik-Komponente in besonders zuverlässiger und effizienter Weise vor Feuchtigkeit geschützt werden.

Die Elektronik-Komponente kann eine Leiterplatte aufweisen (auf der ein oder mehrere elektronische Bauelemente angeordnet sind). Die Leiterplatte und das Abschirmelement können in einem spitzen Winkel zueinander angeordnet sein, insbesondere in einem Winkel von 75° oder weniger. So kann eine Fokussierung des Bypass-Luftstroms zur verbesserten Kühlung der Elektronik-Komponente bewirkt werden.

Wie bereits dargelegt, kann das Gebläse entlang der Hochachse der Saugeinheit oberhalb der Abscheideeinheit angeordnet sein. Ferner kann der Hohlraum entlang der Hochachse unterhalb des Gebläses angeordnet sein. Der Bypass-Kanal kann (innerhalb des Anschlussbereichs des Gehäuses der Saugeinheit) entlang der Hochachse von dem Hohlraum zu dem Eingang des Gebläses verlaufen.

Der Bypass-Kanal kann zumindest in einem Abschnitt entlang der Hochachse oberhalb des Eingangs des Gebläses verlaufen. Dieser Abschnitt des Bypass-Kanals kann derart ausgebildet sein, sodass durch den Abschnitt des Bypass-Kanals ein Fluss von Feuchtigkeit von dem Eingang des Gebläses zu dem Einlass des Bypass-Kanals behindert wird. So kann die Elektronik-Komponente in besonders zuverlässiger Weise vor Feuchtigkeit geschützt werden.

Die Saugeinheit kann derart ausgebildet sein, dass die Abluft des Gebläses (innerhalb des Anschlussbereichs des Gehäuses) entlang der Hochachse, entlang des Bypass-Kanals und entlang der Seitenwand der Abscheideeinheit zu einer entlang der Hochachse unterhalb des Gebläses, insbesondere an der Unterseite der Saugeinheit, angeordneten Auslassöffnung geführt wird. Dabei kann durch das Abschirmelement bewirkt werden, dass keine Feuchtigkeit aus der Abluft in den Hohlraum mit der Elektronik-Komponente gelangt. Durch das Ausströmen der Abluft an der Unterseite der Saugeinheit kann der Komfort der Saugeinheit erhöht werden.

Die Saugeinheit kann somit derart ausgebildet sein, dass innerhalb des Anschlussbereichs des Gehäuses der Saugeinheit die Abluft des Gebläses und der Bypass-Luftstrom nebeneinander verlaufen. Die Abluft und der Bypass-Luftstrom können dabei entgegengesetzte Strömungsrichtungen aufweisen. Insbesondere kann die Abluft entlang der Hochachse von der Oberseite zu der Unterseite der Saugeinheit hinströmen. Andererseits kann der Bypass-Luftstrom entlang der Hochachse von der Unterseite zu der Oberseite der Saugeinheit hinströmen. Der Bypass-Luftstrom wird innerhalb des Bypass-Kanals geführt, und ist somit getrennt von der Abluft (die z. B. innerhalb des Abschlussbereichs des Gehäuses frei zu der Unterseite der Saugeinheit strömt). So kann eine besonders effiziente und zuverlässige Luftführung innerhalb des Gehäuses der Saugeinheit bewirkt werden.

Das Gebläse kann in einer Gebläsekapsel eingebettet sein, wobei die Gebläsekapsel ein Anschlusselement aufweist. Der Auslass des Bypass-Kanals kann mechanisch mit dem Anschlusselement verbunden sein, insbesondere auf das Anschlusselement aufgesteckt sein. So kann eine effiziente und zuverlässige Fixierung des Bypass-Kanals bewirkt werden.

Wie bereits dargelegt kann die Saugeinheit einen elektrischen Energiespeicher aufweisen, der an den ein oder mehreren Einlassöffnungen angeordnet ist, sodass der Bypass-Luftstrom zumindest an einem Teilbereich des Energiespeichers vorbeiströmt. So kann eine besonders effiziente Kühlung des elektrischen Energiespeichers der Saugeinheit bewirkt werden.

Der Saugmund der Saugeinheit weist eine Haupt-Querschnittsfläche auf, und der Bypass-Kanal weist eine Bypass-Querschnittsfläche auf. Die Haupt-Querschnittsfläche ist bevorzugt um den Faktor 10 oder mehr, insbesondere um den Faktor 100 oder mehr, größer als die Bypass-Querschnittsfläche. Als Folge daraus wird durch den Bypass-Kanal keine wesentliche Beeinträchtigung der Saugleistung der Saugeinheit bewirkt.

Die Gehäusewand, die den Hohlraum bildet, kann an der dem Hohlraum zuwandten Innenseite ein oder mehrere Führungsrippen und/oder Führungs-Ausformungen aufweisen, die jeweils ausgebildet sind, den Bypass-Luftstrom durch den Hohlraum an der Elektronik-Komponente vorbeizuführen. Alternativ oder ergänzend kann die Leiterplatte ein oder mehrere Bohrlöcher und/oder Ausfräsungen umfassen, durch die während des Betriebs des Gebläses ein Teil des Bypass-Luftstroms strömt. So kann die Kühlung der Elektronik-Komponente weiter verbessert werden.

Gemäß einem weiteren Aspekt wird eine Saugeinheit für eine handgeführte Saugvorrichtung beschreiben, wobei die Saugeinheit ein Gebläse umfasst, das ausgebildet ist, einen Haupt-Saugluftstrom von dem Saugmund der Saugeinheit, über eine Abscheideeinheit der Saugeinheit zu dem Gebläse der Saugeinheit zu bewirken. Es sei angemerkt, dass die in diesem Dokument beschriebenen Merkmale einzeln oder in Kombination auch für diese Saugeinheit anwendbar sind.

Die Saugeinheit umfasst ein Gehäuse mit einer Gehäusewand, durch die ein Hohlraum gebildet wird, in dem eine Elektronik-Komponente angeordnet ist, die z. B. zur Steuerung des Gebläses ausgebildet ist. Der Hohlraum weist ein oder mehrere Einlassöffnungen in der Gehäusewand auf.

Des Weiteren umfasst die Saugeinheit einen Bypass-Kanal, der einen dem Hohlraum zugewandten Einlass und einen dem Gebläse zugewandten Auslass aufweist. Das Gebläse ist ausgebildet, einen Bypass-Luftstrom von den ein oder mehreren Einlassöffnungen, durch den Hohlraum, durch den Bypass-Kanal zu dem Gebläse zu bewirken.

Der Einlass des Bypass-Kanals stellt bevorzugt eine Verengung in Bezug auf den Hohlraum dar, sodass der Bypass-Luftstrom innerhalb des Hohlraums zu dem Einlass des Bypass-Kanals hin beschleunigt und/oder verdichtet wird. So kann eine besonders zuverlässige und effiziente Kühlung der Elektronik-Komponente der Saugeinheit bewirkt werden.

Gemäß einem weiteren Aspekt wird eine Saugvorrichtung, insbesondere ein handgeführter Staubsauger (mit Wischfunktion), beschrieben, der die in diesem Dokument beschriebene Saugeinheit umfasst.

Es ist zu beachten, dass jegliche Aspekte der in diesem Dokument beschriebenen Saugeinheit und der in diesem Dokument beschriebenen Saugvorrichtung in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen:
- Figur 1: eine beispielhafte Saugvorrichtung mit einer Saugeinheit, einem Saugrohr und einer Düse;
- Figur 2a: eine Saugeinheit mit einem Bypass-Kanal;
- Figur 2b: eine Elektronik-Komponente der Saugeinheit;
- Figur 2c: den Haupt-Saugluftstrom und den Bypass-Luftstrom der Saugeinheit;
- Figuren 3a und 3b: unterschiedliche Ansichten der Gebläsekapsel; und
- Figur 4: ein beispielhaftes Abschirmelement zur Abschirmung der Elektronik-Komponente.

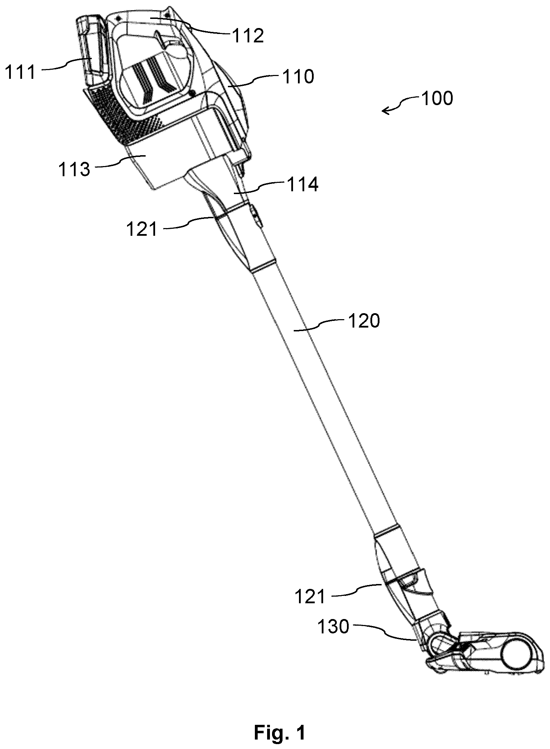

Wie eingangs dargelegt, befasst sich das vorliegende Dokument damit, eine effiziente und zuverlässige Kühlung der Elektronik einer Saugeinheit einer Saugvorrichtung zu bewirken, die auch als Saug-Wischer genutzt werden kann. In diesem Zusammenhang zeigt Fig. 1 einen beispielhaften (Hand-) Staubsauger 100 (als Beispiel für eine Saugvorrichtung), der eine Saugeinheit 110 mit einem elektrischen Energiespeicher 111 aufweist. Die Saugeinheit 110 weist einen (Hand-) Griff 112 auf, der von einem Nutzer mit einer Hand umgriffen werden kann, um die Saugeinheit 110 zu halten. Durch das Gebläse der Saugeinheit 110 wird ein Saugluftstrom durch den Saugmund 114 der Saugeinheit 110, über eine Abscheideeinheit 113 der Saugeinheit 110 bis zu dem Gebläse bewirkt. Die Saugeinheit 110 kann ausgebildet sein, eigenständig als Saugvorrichtung verwendet zu werden.

An die Saugeinheit 110 kann über eine Kupplung 121 ein Zubehörteil 120, 130 angeschlossen werden. In dem dargestellten Beispiel ist die Saugeinheit 110 über eine Kupplung 121 mit einem Saugrohr 120 verbunden, das wiederum über eine Kupplung 121 mit einer Bodendüse 130 verbunden ist. Die Bodendüse 130 kann als Nassreinigungsdüse ausgebildet sein.

Der von dem Gebläse der Saugeinheit 110 erzeugte Saugluftstrom kann dazu verwendet werden, eine Elektronik-Komponente und/oder den Energiespeicher 111 der Saugeinheit 110 zu kühlen. Bei Verwendung einer Nassreinigungsdüse kann der Saugluftstrom Feuchtigkeit enthalten, die die Elektronik-Komponente und/oder den Energiespeicher 111 schädigen können.

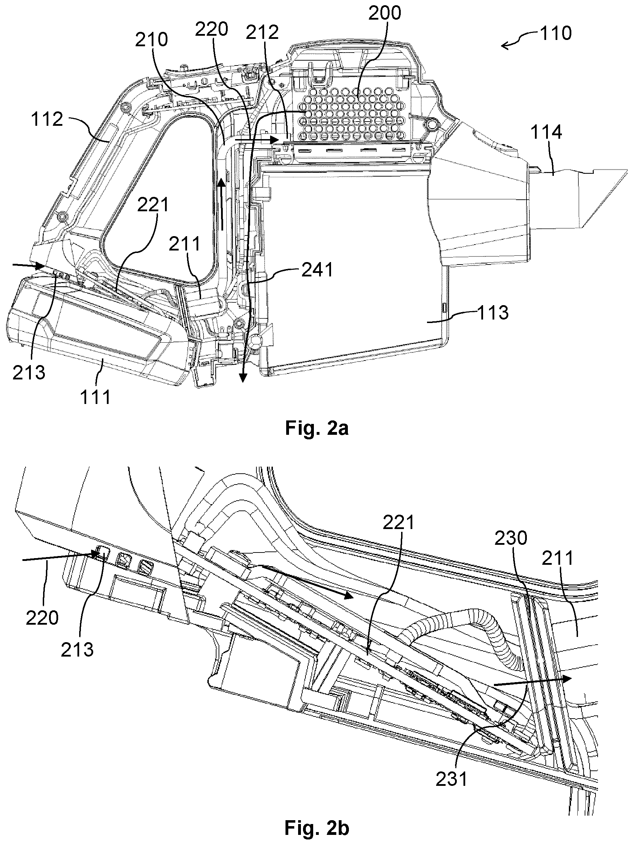

Figuren 2a bis 2c zeigen unterschiedliche Ansichten einer Saugeinheit 110, die einen Bypass-Kanal 210 aufweist, der fluidleitend mit dem Gebläse 200 gekoppelt ist, sodass durch das Gebläse 200 ein Bypass-Luftstrom 220 in dem Bypass-Kanal 210 bewirkt werden kann. Der Bypass-Kanal 210 kann durch einen Schlauch gebildet werden. Der Bypass-Kanal 210 verläuft von dem Gebläse 200, durch das Gehäuse der Saugeinheit 110 in Richtung zu der Elektronik-Komponente 221 und/oder dem Energiespeicher 111 der Saugeinheit 110, sodass der Bypass-Luftstrom 220 an der Elektronik-Komponente 221 und/oder an dem Energiespeicher 111 vorbeiströmt.

Wie insbesondere aus Fig. 2b ersichtlich, kann die Elektronik-Komponente 221 durch ein Abschirmelement 230 von dem Gebläse 200 abgeschirmt sein, insbesondere um zu vermeiden, dass Feuchtigkeit von dem Gebläse 200 und/oder von der Abluft 241 des Gebläses 200 zu der Elektronik-Komponente 221 gelangt. Der Bypass-Kanal 210 kann auf der dem Gebläse 200 zugewandten Seite des Abschirmelements 230 angeordnet sein, und die Elektronik-Komponente 221 kann an der von dem Gebläse 200 abgewandten Seite des Abschirmelements 230 angeordnet sein. Das Abschirmelement 230 kann eine abgedichtete Öffnung 231 aufweisen, in der der Einlass 211 des Bypass-Kanals 210 angeordnet ist. So kann bewirkt werden, dass der Bypass-Luftstrom 220 über die Elektronik-Komponente 221, durch die Öffnung 231 der Abschirmeinheit 230 in den Einlass 211 des Bypass-Kanals 210 gelangt.

Die Elektronik-Komponente 221 wird von der Gehäusewand des Griffs 112 der Saugeinheit 110 umschlossen. Die Gehäusewand weist ein oder mehrere Eintrittsöffnungen 213 auf, über die der Bypass-Luftstrom 220 von außen in das Gehäuse und zu der Elektronik-Komponente 221 gelangt. Die ein oder mehreren Eintrittsöffnungen 213 sind an der von dem Einlass 211 des Bypass-Kanals 210 abgewandten Seite der Elektronik-Komponente 221 angeordnet, sodass der Bypass-Luftstrom 220 von den ein oder mehreren Eintrittsöffnungen 213, über die Elektronik-Komponente 221 zu dem Einlass 211 des Bypass-Kanals 210 strömt, und dabei die Elektronik-Komponente 221 kühlt.

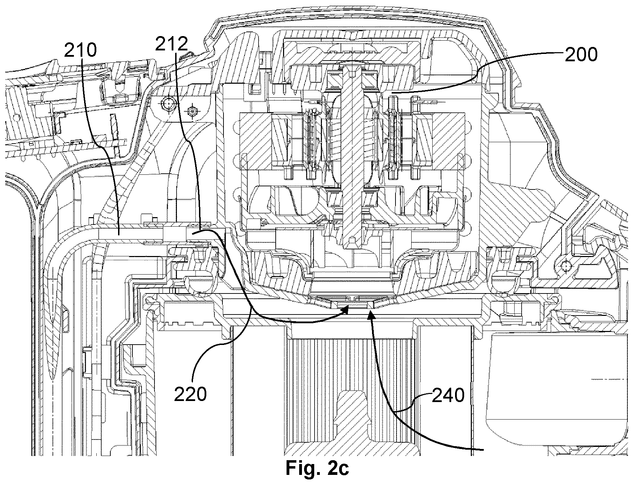

Wie aus Fig. 2c ersichtlich, wird somit von dem Gebläse 200 neben dem Haupt-Saugluftstrom 240 (der durch die Abscheideeinheit 113 der Saugeinheit 110 strömt, wie in Fig. 2a dargestellt) der Bypass-Luftstrom 220 durch den Bypass-Kanal 210 bewirkt.

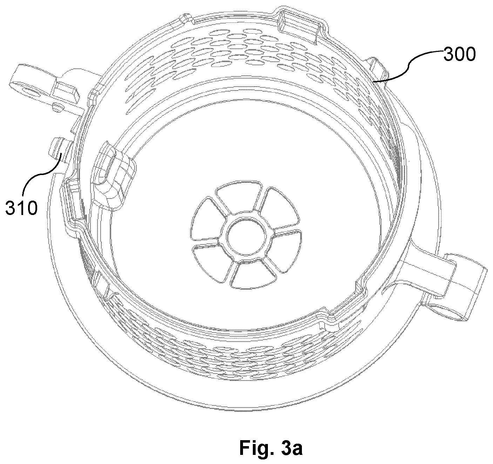

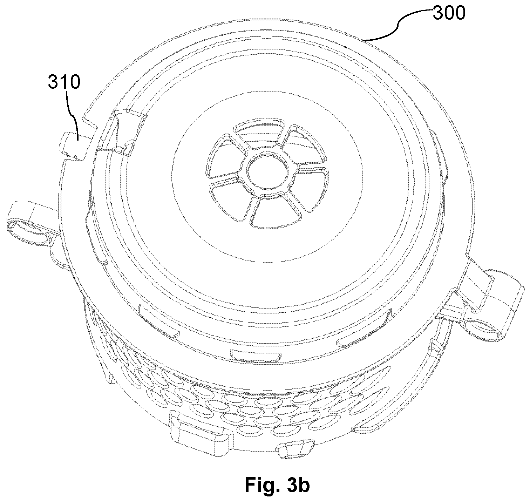

Figuren 3a und 3b zeigen unterschiedliche Ansichten der Gebläsekapsel 300, die das Gebläse 200 umschließt. Die Gebläsekapsel 300 kann ein Anschlusselement 310 zum Anschluss des Auslasses 212 des Bypass-Kanals 210 aufweisen. Der Auslass 212 des Bypass-Kanal 210 kann z. B. auf das Anschlusselement 310 aufgeschoben werden, um den Auslass 212 des Bypass-Kanals 210 an der Gebläsekapsel 300 zu fixieren. So kann der Bypass-Luftstrom 220 in besonders stabiler Weise bewirkt werden.

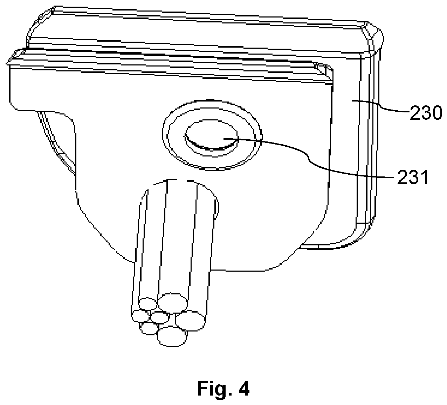

Fig. 4 zeigt ein beispielhaftes Abschirmelement 230 mit der abgedichteten Öffnung 231 für den Einlasse 211 des Bypass-Kanals 210.

Es kann somit die Kühlung der Elektronik 221 in dem Handgriff 112 der Saugeinheit 110 durch eine Frischluftzufuhr bewirkt werden, die durch einen Nebenluftkanal (d. h. durch den Bypass-Kanal 210) eingezogen wird. In der Saugeinheit 110 (d. h. in dem Handstück der Saugvorrichtung 100) können der Sammelbehälter (als Teil der Abscheideeinheit 113), das Gebläse 200, der Handgriff 112, die Steuerelektronik 221 für das Gebläse 200 und/oder eine Halterung für den elektrischen Energiespeicher 111 integriert sein. Der von dem Rohr (d. h. dem Saugmund 114) zugeführte Luftstrom 240 wird durch den Sammelbehälter und den Filter der Abscheideeinheit 113 zu dem Gebläse 200 geleitet. Des Weiteren kann die Abluft 241 von dem Gebläse 200 weiter in den Handgriff 112 und/oder durch den Anschlussbereich des Gehäuses der Saugeinheit (zu der Unterseite der Saugeinheit 110) geleitet werden (wie beispielhaft in Fig. 2a dargestellt).

Die Kühlung der Elektronik 221 wird durch einen Bypass-Kanal 220 bewirkt, durch den Frischluft von außen in den Handgriff 112 gesogen wird. Nahe dem Eingang des Gebläses 200 ist ein Bypass-Kanal 210 (insbesondere ein Bypass-Schlauch) positioniert. Im Betrieb wird durch den von dem Gebläse 200 erzeugten Unterdruck am Eingang des Gebläses ein Luftstrom 220 aus dem Bypass-Kanal 210 eingesogen. Die Luft, die auf der Kanal-Eingangsseite 211 in den Bypass-Kanal 210 gesaugt wird, stammt aus einem (nahezu) abgeschlossenen Hohlraum des Handgriffs 112, in dem die Elektronik 221 angeordnet ist. Durch ein oder mehrere Eintrittsöffnungen 213 an der Gehäusewand nahe der Halterung für den Energiespeicher 111 strömt Frischluft nach und umströmt dabei die Elektronik 221. Der Bereich des Handgriffs 112, in dem die Elektronik 221 positioniert ist, kann durch Schotten (d. h. durch eine Abschirmeinheit 230) von dem restlichen Inneren des Handgriffs 112 abgetrennt sein, sodass die von dem Gebläse 200 in den Handgriff 112 und/oder in den Anschlussbereich des Gehäuses der Saugeinheit 110 geleitete Abluft 241 des Gebläses 200 nicht bis zu der Elektronik 221 gelangt und sich somit nicht mit der Frischluft mischen kann, bevor sie über Austrittsöffnungen im Gehäuse der Saugeinheit 110 (an der Unterseite der Saugeinheit 110) die Saugeinheit 110 verlässt.

Durch die Anordnung der ein oder mehreren Eintrittsöffnungen 213 für die Frischluft im Bereich der Halterung des Energiespeichers 111 wird eine gleichzeitige Kühlung der Elektronik 221 und des Energiespeichers 111 ermöglicht. Sowohl das Gehäuse des Energiespeichers 111 als auch die Elektronik 221 werden dabei von Luft umspült, die die Umgebungstemperatur aufweist und somit merklich kühler als die Ausblasluft 241 des Gebläses 200 ist. Im Hohlraum des Handgriffes 112 mit der integrierten Elektronik 221 wird die zum Bypass-Kanal 210 nachströmende Frischluft um die Elektronik 221 herumgeführt und überstreicht dabei große Teile der Platine (d. h. der Leiterplatte) der Elektronik 221 bzw. der Elektronik 221 statt nur punktuell auf einen kleinen Abschnitt ausgerichtet zu sein. Die ein oder mehreren Eintrittsöffnungen 213 für die Frischluft liegen bevorzugt im Gehäuse seitlich unterhalb der Elektronikplatine, während die Eingangsseite 211 des Bypass-Kanals 210 oberhalb der Elektronikplatine liegt. Die zum Bypass-Kanal 210 gesaugte Luft umströmt somit die gesamte Platine, bevor sie sich am Eingang 211 des Bypass-Kanals 210 fokussiert. Die in diesem Abschnitt der Elektronik 221 angeordneten Elektronikbauteile werden daher besonders gekühlt, da sich die Strömungsgeschwindigkeit und die Strömungsdichte in der Nähe des Eingangs 211 des Bypass-Kanals 210 erhöhen.

Das am Eingang 211 des Bypass-Kanals 210 liegende Schott 230 (d. h. das Abschirmelement) im Handgriff 112 ist bevorzugt gegenüber der Elektronikplatine 221 in einem bestimmten Winkel (schräg) angeordnet, sodass die Platine 221 und das Schott 230 einen spitzen Winkel einschließen. Diese Anordnung verringert das Volumen des Hohlraumes im ungenutzten Bereich und unterstützt das Zuführen der Luft in den Bypass-Kanal 210 sowie die Konzentration der Luft im Bereich nahe des Eingangs 211 des Bypass-Kanals 210.

Die Menge der zur Kühlung der Elektronik 221 eingesaugten Frischluft kann über den Innendurchmesser des Bypass-Kanals 210 eingestellt werden. Das Verhältnis des Innendurchmessers des Bypass-Kanals 210 zu dem Innendurchmesser des Ansaugrohres 114 (d. h. des Saugmunds) definiert im Wesentlichen die Menge der Frischluft. Der Innendurchmesser des Bypass-Kanals 210 kann z. B. 3 mm betragen, und der Innendurchmesser des Ansaugrohres 114 kann 30 mm betragen, so dass die Fläche des Querschnitts des Bypass-Kanals 210 beispielsweise ein Hundertstel der Fläche des Querschnitts des Ansaugrohres 114 aufweist.

Der Luftstrom 220 aus dem Bypass-Kanal 210 verlässt den Bypass-Kanal 210 an einer Ankopplung 310 seitlich des Gebläses 200. Die Luft 220 wird von dort an den Eingang des Gebläses 200 geführt, wo sie sich mit der aus dem Sammelbehälter angesaugten Luft 240 mischt und in das Gebläse 200 gesogen wird. Durch die erhöhte Lage des Ausgangs 212 des Bypass-Kanals 210 gegenüber dem Eingang des Gebläses 200 und die damit verbundene, erweiterte Entfernung des Bypass-Kanals 210 zu dem Feuchtigkeitführenden Luftstrom 240 aus der Sammelbox sind keine zusätzlichen Vorkehrungen wie z. B. Filter notwendig, um den Bypass-Kanal 210 vor Feuchtigkeit oder Staub zu schützen.

Für den Bypass-Kanal 210, insbesondere für den Bypass-Schlauch, kann ein formstabiles Material (z. B. PE (Polyethylen)) eingesetzt werden. In den Gehäuseschalen des Handgriffs 112 sind bevorzugt Fixierungsrippen eingebracht, die den Bypass-Kanal 210 zusätzlich in seiner Form stabilisieren. Durch die Fixierungsrippen ist der Bypass-Kanal 210 so verlegt und sind seine Enden 211, 212 bevorzugt so ausgerichtet, dass der Bypass-Kanal 210 in Strömungsrichtung angestellt ist, und somit keine wesentliche Geräuschentwicklung entsteht und kein wesentlicher Strömungswiderstand verursacht wird.

Der Querschnitt des Bypass-Kanals 210 kann (z. B. mit einem Außendurchmesser von 5 mm und einem Innendurchmesser von 3 mm) so gewählt sein, dass ein optimaler Luftdurchsatz zur Elektronikkühlung sichergestellt ist und gleichzeitig mögliche Schwingungen des Bypass-Kanals 210 minimiert werden. Des Weiteren stellt die Wandstärke (z. B. von 1 mm) des Bypass-Kanals 210 eine Form- und Verzugsstabilität gegen die von außen einwirkende Erwärmung durch die an der Außenseite des Bypass-Kanals 210 entlangströmende, erwärmte Ausblasluft 241 sicher.

Das zur Elektronik 221 ausgerichtete Ende 211 des Bypass-Kanals 210 ist (zum Schutz gegen Feuchtigkeit) bevorzugt direkt in der Gummidichtung der Elektronikabschirmung 230 fixiert. Das zum Gebläse 200 führende Ende 212 des Bypass-Kanals 210 kann mittels einer flexiblen, elastischen Ankopplung 310 (etwa ein Zwischenstück in Form z. B. eines Silikonschlauches) an die Gebläsekapsel 300 angebunden sein. Dadurch ist der Bypass-Kanal 210 gegen schwingende Teile (bspw. das Gebläse 200) entkoppelt und kann Erschütterungen (z. B. bei einem Gerätesturz) abfedern, ohne dass die Funktion beeinträchtigt wird.

Der kühlende Luftstrom 220 ist frei von aufgesaugter Feuchtigkeit und kann ggf. auch das Gehäuse des Energiespeichers 111 kühlen, da Frischluft von außen angesaugt wird. Die Elektronik 221 kann selbst bei Betrieb mit einem beschädigten oder unachtsam ausgebauten Filter der Abscheideeinheit 113 nicht mit Feuchtigkeit aus der Düse 130 und/oder mit aufgesaugtem Staub in Kontakt kommen, da sie durch Schotten 230 (d. h. durch das Abschirmelement) von der Ausblasluft 241 getrennt ist.

In dem Hohlraum der Elektronik 221 können zusätzliche Rippen oder Ausformungen integriert werden, die eine erweiterte bzw. verbesserte Luftführung um die Elektronik 221 herum realisieren. Der Luftstrom 220 innerhalb des Hohlraumes kann so an besonders zu kühlende Stellen der Elektronik 221 geführt, dort konzentriert und beschleunigt werden oder an einer anderen Stelle breiter über weite Flächen der Elektronikplatine geführt werden.

Die Elektronikplatine selbst kann mit Bohrlöchern oder Ausfräsungen versehen werden, um den Luftfluss im Bereich der Elektronik zu verbessern und/oder um Luft an gewünschten Stellen auch innerhalb des Umfangs der Platine auf die andere Seite der Platine zu leiten.

Durch die in diesem Dokument beschriebenen Maßnahmen wird eine Kühlung der Elektronik 211 durch frische Umgebungsluft von außen bewirkt, die typischerweise kühler ist als die Ausblasluft 241 des Gebläses 200. Es kann eine gleichzeitige Kühlung des Energiespeichers 111 und der Elektronik 221 bewirkt werden, da die Luft 220, die durch die Eingangsöffnungen 213 in das Gehäuse gezogen wird, auch über das Gehäuse des Energiespeichers 111 streicht. Es kann eine Kühlung der gesamten Elektronikplatine bewirkt werden, da die Frischluft die Platine vollständig umströmt und nicht nur (punktuell) Warmluft abzieht.

Der Bypass-Luftstrom 220 zur Kühlung ist von dem Haupt-Saugluftstrom getrennt, so dass Feuchtigkeit und/oder Staub/Schmutz nicht in den Bypass-Luftstrom 220 gelangen können. Die Elektronik 221 ist somit vor Feuchtigkeit geschützt und liegt nicht im staubbeaufschlagten Raum. Selbst bei einem beschädigten oder ausgebauten Filter der Abscheideeinheit 113 kann die Elektronik 221 nicht mit Staub in Kontakt kommen. Der Frischluftstrom 220 sorgt darüber hinaus für ein stetiges Absaugen von Staub der Elektronik 221.

Die von der Elektronik 221 abgeführte, erwärmte Luft wird über den Bypass-Kanal 210 dem Gebläse 200 zugeführt und mit der über den Saugkanal angesogenen Luft 240 im Ansaugbereich (d. h. am Eingang) des Gebläses 200 gemischt. Der Luftstrom ist ab dem Gebläse 200 somit wärmer als die restliche Umgebungsluft. Da erwärmte Luft mehr Feuchtigkeit aufnehmen kann als kühlere Luft, kann die in der Ansaugluft enthaltene Feuchtigkeit besser im Luftstrom gehalten werden. Dadurch sinkt die Tendenz zur Kondensation der Feuchtigkeit innerhalb der Saugeinheit 110, sodass eine Beeinträchtigung der Saugeinheit 110, insbesondere des Gebläses 200, durch Feuchtigkeit reduziert werden kann.

Es wird somit eine Kühlung einer Elektronikplatine 221 in einem Handstaubsauger 100, 110, bei dem die Energieversorgung und die Elektronik am/im Handgriff 112 angeordnet sind, durch einen Bypass-Kanal 210 beschrieben. Die ein oder mehreren Kühlluftöffnungen 213 befinden sich ebenfalls im Handgriff 112.

Durch den Bypass-Kanal 210 strömt von außen angesaugte Frischluft 220, um die Elektronik 221 und den Energiespeicher 111 zu kühlen, sodass eine zusätzliche Baueinheit zur Feuchtigkeitsabscheidung aus dem Haupt-Saugluftstrom 240 und/oder ein Coating der Elektronik 221 umgangen werden können.

Bei Betrieb des Gebläses 200 wird Kühlluft 220 durch die Öffnungen 213 am Handgriff 112 angesaugt und über den Energiespeicher 111 und die Elektronik 221 geführt, um diese zu kühlen. Dabei kann die Kühlluft 220 frei über die Elektronik 221 strömen. Über eine (abgedichtete) luftstromabwärts angeordnete Verengung 231 (nach der Elektronik 221) wird die erwärmte Kühlluft über einen Bypass-Kanal 210 (insbesondere einen Schlauch) dem Gebläse 200 zugeführt. Die Zuführung erfolgt vor dem Gebläse 200 zusammen mit dem Haupt-Saugluftstrom 240. Im Gebläse 200 wird die Kühlluft mit der staubbeladenen Luft (d. h. dem Haupt-Saugluftstrom 240) gemischt und dann nach außen über die Öffnungen im Handgriff 112 bzw. in dem Anschlussbereich des Gehäuses der Saugeinheit 110 an die Umgebung abgeben. Die luftstromabwärts angeordnete Verengung 231 ermöglicht eine komplette Umströmung der Elektronik 221 mit Kühlluft. Der Bypass-Kanal 210 ermöglicht eine widerstandsarme Führung der Kühlluft.

Es wird somit ein handgeführter und/oder akkubetriebener Staubsauger 100 beschrieben, der eine Motor-Gebläseeinheit 200 zur Erzeugung von Saugluft 220, 240 aufweist. Der Staubsauger 100 umfasst einem Hauptluftkanal von einer Eintrittsöffnung (z. B. eine Düse 130) über eine Staubabscheideeinheit 113 zu der Motor-Gebläseeinheit 200. Des Weiteren umfasst der Staubsauger 110 einen Nebenluftkanal 210 von einer Eintrittsöffnung 213, die am Gehäuse des Staubsaugers 100 angeordnet ist. Der Staubsauger 100 weist ferner eine zu kühlenden Elektronik 221 in dem Gehäuse auf, wobei die Elektronik 221 in dem Nebenluftkanal angeordnet ist.

In dem Nebenluftkanal 210 kann eine Verengung 231 angeordnet sein, wobei die Verengung 231 luftstromabwärts zu der kühlenden Elektronik 221 angeordnet ist. Ausgehend von der Verengung 231 kann die Kühlluft 220 direkt und/oder unmittelbar dem Gebläse 200 zuführt werden. Dabei kann die Kühlluft über einen Schlauch abgeleitet werden. Die Verengung kann die Öffnung bzw. den Einlass 211 von dem Schlauch darstellen.

Die Öffnung 213 des Hohlraums kann an dem Handgriff 112 des Staubsaugers 100 angeordnet sein. Die Nebenluft 220 kann oberhalb des Energiespeichers 111 (durch die Öffnung 213) angesaugt werden, und kann derart ausgebildet sein, dass die Nebenluft 220 den Energiespeicher 111 kühlt.

Die Eintrittsöffnung 310 der Kühlluft am Ende 212 des Kanals 210 kann bei der Gebläsekapsel 300 der Motor-Gebläse-Einheit 200 so angeordnet sein, dass die Kühlluft 220 unmittelbar vor einem Eingriffsschutzelement der Gebläsekapsel 300 mit dem Haupt-Saugluftstrom 240 vermischt wird.

Die vorliegende Erfindung ist nicht auf die gezeigten Ausführungsbeispiele beschränkt. Insbesondere ist zu beachten, dass die Beschreibung und die Figuren nur das Prinzip der Saugeinheit 110 und/oder der Saugvorrichtung 100 veranschaulichen sollen.

### Bezugszeichenliste

- 100: Saugvorrichtung (Saug-Wischer)
- 110: Saugeinheit
- 111: elektrischer Energiespeicher
- 112: Griff
- 113: Abscheideeinheit
- 114: Saugmund
- 120: Zubehörteil (Saugrohr)
- 121: Kupplung
- 130: Düse (z. B. Nassreinigungsdüse)
- 200: Gebläse
- 210: Bypass-Kanal
- 211: Einlass (Bypass-Kanal)
- 212: Auslass (Bypass-Kanal)
- 213: Eintrittsöffnung
- 220: Bypass-Luftstrom
- 221: Elektronik-Komponente
- 230: Abschirmelement
- 231: Öffnung
- 240: Haupt-Saugluftstrom
- 241: Abluft
- 300: Gebläsekapsel
- 310: Anschlusselement (für Bypass-Kanal)

## Patentansprüche

1. Saugeinheit (110) für eine handgeführte Saugvorrichtung (100); wobei die Saugeinheit (110) umfasst,
- ein Gebläse (200), das ausgebildet ist, einen Haupt-Saugluftstrom (240) von einem Saugmund (114), über eine Abscheideeinheit (113) zu dem Gebläse (200) der Saugeinheit (110) zu bewirken;
- einen Handgriff (112) mit einem durch eine Gehäusewand gebildeten Hohlraum, in dem eine Elektronik-Komponente (221) angeordnet ist; wobei der Hohlraum ein oder mehrere Einlassöffnungen (213) in der Gehäusewand aufweist; und
- einen Bypass-Kanal (210), der einen dem Hohlraum zugewandten Einlass (211) und einen dem Gebläse (200) zugewandten Auslass (212) aufweist; wobei das Gebläse (200) ausgebildet ist, einen Bypass-Luftstrom (220) von den ein oder mehreren Einlassöffnungen (213), durch den Hohlraum, durch den Bypass-Kanal (210) zu dem Gebläse (200) zu bewirken; wobei der Hohlraum an der dem Einlass (211) des Bypass-Kanals (210) zugewandten Seite durch ein Abschirmelement (230) bedeckt ist, das ausgebildet ist, den Hohlraum von Feuchtigkeit aus dem Haupt-Saugluftstrom (240) und/oder aus Abluft (241) des Gebläses (200) abzuschirmen; und wobei das Abschirmelement (230) eine abgedichtete Öffnung (231) aufweist, in der der Einlass (211) des Bypass-Kanals (210) angeordnet ist.

2. Saugeinheit (110) gemäß Anspruch 1, wobei
- die Elektronik-Komponente (221) eine dem Einlass (211) des Bypass-Kanals (210) zugewandte erste Kante aufweist;
- die ein oder mehreren Einlassöffnungen (213) an einer von dem Einlass (211) des Bypass-Kanals (210) abgewandten zweiten Kante der Elektronik-Komponente (221) angeordnet sind; und
- die erste und die zweite Kante der Elektronik-Komponente (221) insbesondere einander gegenüber angeordnet sind.

3. Saugeinheit (110) gemäß einem der vorhergehenden Ansprüche, wobei
- die Elektronik-Komponente (221) eine erste Seite und eine, der ersten Seite gegenüberliegende, zweite Seite aufweist;
- die ein oder mehreren Einlassöffnungen (213) der ersten Seite der Elektronik-Komponente (221) zugewandt sind; und
- der Einlass (211) des Bypass-Kanals (210) der zweiten Seite der Elektronik-Komponente (221) zugewandt ist.

4. Saugeinheit (110) gemäß einem der vorhergehenden Ansprüche, wobei der Einlass (211) des Bypass-Kanals (210) eine Verengung in Bezug auf den Hohlraum darstellt, sodass der Bypass-Luftstrom (220) innerhalb des Hohlraums zu dem Einlass (211) des Bypass-Kanals (210) hin beschleunigt und/oder verdichtet wird.

5. Saugeinheit (110) gemäß einem der vorhergehenden Ansprüche, wobei
- die Elektronik-Komponente (221) eine Leiterplatte aufweist; und
- die Leiterplatte und das Abschirmelement (230) in einem spitzen Winkel zueinander angeordnet sind, insbesondere in einem Winkel von 75° oder weniger.

6. Saugeinheit (110) gemäß einem der vorhergehenden Ansprüche, wobei
- das Gebläse (200) entlang einer Hochachse der Saugeinheit (110) oberhalb der Abscheideeinheit (113) angeordnet ist;
- der Hohlraum entlang der Hochachse unterhalb des Gebläses (200) angeordnet ist; und
- der Bypass-Kanal (210) entlang der Hochachse von dem Hohlraum zu einem Eingang des Gebläses (200) verläuft.

7. Saugeinheit (110) gemäß Anspruch 6, wobei der Bypass-Kanal (210) zumindest in einem Abschnitt entlang der Hochachse oberhalb des Eingangs des Gebläses (200) verläuft, sodass durch den Abschnitt des Bypass-Kanals (210) ein Fluss von Feuchtigkeit von dem Eingang des Gebläses (200) zu dem Einlass (211) des Bypass-Kanals (210) behindert wird.

8. Saugeinheit (110) gemäß einem der Ansprüche 6 bis 7, wobei die Saugeinheit (110) derart ausgebildet ist, dass Abluft (241) des Gebläses (200) entlang der Hochachse, entlang des Bypass-Kanals (210) und entlang einer Seitenwand der Abscheideeinheit (113) zu einer entlang der Hochachse unterhalb des Gebläses (220) angeordneten Auslassöffnung geführt wird.

9. Saugeinheit (110) gemäß einem der vorhergehenden Ansprüche, wobei der Bypass-Kanal (210) einen Bypass-Schlauch umfasst.

10. Saugeinheit (110) gemäß einem der vorhergehenden Ansprüche, wobei
- das Gebläse (200) in einer Gebläsekapsel (300) eingebettet ist;
- die Gebläsekapsel (300) ein Anschlusselement (310) aufweist; und
- der Auslass (212) des Bypass-Kanals (210) mechanisch mit dem Anschlusselement (310) verbunden ist, insbesondere auf das Anschlusselement (310) aufgesteckt ist.

11. Saugeinheit (110) gemäß einem der vorhergehenden Ansprüche, wobei die Saugeinheit (110) einen elektrischen Energiespeicher (111) aufweist, der an den ein oder mehreren Einlassöffnungen (213) angeordnet ist, sodass der Bypass-Luftstrom (220) zumindest an einem Teilbereich des Energiespeichers (111) vorbeiströmt.

12. Saugeinheit (110) gemäß einem der vorhergehenden Ansprüche, wobei
- der Saugmund (114) eine Haupt-Querschnittsfläche aufweist;
- der Bypass-Kanal (210) eine Bypass-Querschnittsfläche aufweist; und
- die Haupt-Querschnittsfläche um einen Faktor 10 oder mehr, insbesondere um einen Faktor 100 oder mehr, größer als die Bypass-Querschnittsfläche ist.

13. Saugeinheit (110) gemäß einem der vorhergehenden Ansprüche, wobei die Gehäusewand, die den Hohlraum bildet, an einer dem Hohlraum zuwandten Innenseite ein oder mehrere Führungsrippen und/oder Führungs-Ausformungen aufweist, die jeweils ausgebildet sind, den Bypass-Luftstrom (220) durch den Hohlraum an der Elektronik-Komponente (221) vorbeizuführen.

14. Saugeinheit (110) gemäß einem der vorhergehenden Ansprüche, wobei
- die Elektronik-Komponente (221) eine Leiterplatte umfasst; und
- die Leiterplatte ein oder mehrere Bohrlöcher und/oder Ausfräsungen umfasst, durch die während des Betriebs des Gebläses (200) ein Teil des Bypass-Luftstroms (220) strömt.
